Europäisches Patentamt

European Patent Office

Office européen des brevets

(19)

(11) Veröffentlichungsnummer : **0 290 628 B1**

(12) **EUROPÄISCHE PATENTSCHRIFT**

(45) Veröffentlichungstag der Patentschrift :
**22.01.92 Patentblatt 92/04**

(51) Int. Cl.$^5$ : **C30B 15/34**

(21) Anmeldenummer : **88900260.6**

(22) Anmeldetag : **23.10.87**

(86) Internationale Anmeldenummer :
**PCT/SU87/00117**

(87) Internationale Veröffentlichungsnummer :
**WO 88/03967 02.06.88 Gazette 88/12**

(54) **ANORDNUNG ZUR ZÜCHTUNG PROFILIERTER MONOKRISTALLE.**

(30) Priorität : **26.11.86 SU 4149059**

(43) Veröffentlichungstag der Anmeldung :
**17.11.88 Patentblatt 88/46**

(45) Bekanntmachung des Hinweises auf die
Patenterteilung :
**22.01.92 Patentblatt 92/04**

(84) Benannte Vertragsstaaten :
**AT CH DE FR GB IT LI SE**

(56) Entgegenhaltungen :
**DE-C- 2 325 104**
**US-A- 3 868 228**
**P.I. Antonov et al. " Poluchenie profilirovan-**
**nykh monokristallov i izdely sposobom Stepa-**
**nova ",1981, Nauka, Leningrad, see page 139**

(73) Patentinhaber : **VSESOJUZNY**
**NAUCHNO-ISSLEDOVATELSKY**
**PROEKTNO-KONSTRUKTORSKY I**
**TEKHNOLOGICHESKY INSTITUT**
**ELEKTROTERMICHESKOGO**
**OBORUDOVANIA**
**VNIIETO, ul. Nizhegorodskaya, 29**
**Moscow 109052 (SU)**

(72) Erfinder : **KRAVETSKY, Dmitry Yakovlevich**
**ul. Bibliotechnaya, 13-91**
**Moscow, 109544 (SU)**
Erfinder : **ZATULOVSKY, Lev Markovich**
**Orlikov per., 8-55**
**Moscow, 107078 (SU)**
Erfinder : **EGOROV, Leonid Petrovich**
**ul. Profsojuznaya, 75-1-92**
**Moscow, 117342 (SU)**
Erfinder : **PELTS, Boris Bentsionovich**
**ul. Lesnaya, 63/43-157**
**Moscow, 103066 (SU)**
Erfinder : **OKUN, Leonid Samuilovich**
**ul. Udaltsova, 4-306**
**Moscow, 117415 (SU)**
Erfinder : **AVERYANOV, Viktor Vasilievich**
**ul. Energeticheskaya, 10-2-95**
**Moscow, 111116 (SU)**
Erfinder : **FREIMAN, Efim Alexandrovich**
**ul. 2-aya Vladimirskaya, 15-1-53**
**Moscow, 111401 (SU)**
Erfinder : **ALISHOEV, Alexandr, Lvovich**
**Kronshtadtsky bulvar, 13-2-168**
**Moscow, 125493 (SU)**

(74) Vertreter : **Finck, Dieter et al**
**Patentanwälte v. Füner, Ebbinghaus, Finck**
**Mariahilfplatz 2 & 3**
**W-8000 München 90 (DE)**

EP 0 290 628 B1

## Beschreibung

Technisches Gebiet

Die vorliegende Erfindung bezieht sich auf die Kristallzüchtung aus Schmelzen und betrifft ein Verfahren zur Züchtung von Einkristallen hochschmelzender optisch durchsichtiger Metallverbindungen, und insbesondere ein Verfahren zur Züchtung von profilierten Einkristallen.

Zugrundeliegender Stand der Technik

Die Güte profilierter Einkristalle, und zwar die Genauigkeit geometrischer Abmessungen, die Beständigkeit gegen elektrischen Durchschlag, die Grösse integraler Lichtdurchlässigkeit, kristallografische Desorientierung der Bausteine von Einkristallen und mechanische Festigkeit, hängt von der Temperaturführung in der Zone der Kristallisierung und Einkristallstreckung sowie von dem Abkühlverfahren des Einkristalls ab. Der Hauptfaktor, der die Güte von Einkristallen bestimmt, ist also der Charakter des Temperaturfeldes im System "Schmelze - Einkristall". Das Schmelzen des Ausgangsstoffes muss bei einer möglichst minimalen Überhitzung, die eine spontane Kristallisation der Schmelze nicht zulässt, durchgeführt werden. Das reduziert seine Dissoziation und die Wechselwirkung mit dem Tiegelmaterial, die zur Vergrösserung der Menge von artfremden Einschlüssen und Mikroblasen im Einkristall beitragen, die die Lichtdurchlässigkeit des Einkristalls und seine Beständigkeit gegen elektrischen Durchschlag vermindern.

Das Temperaturfeld in der Zone der Einkristallbildung soll derartig sein, damit es ermöglicht, einen profilierten Einkristall mit einer vorgegebenen Genauigkeit der geometrischen Abmessungen zu erhalten; es soll beispielsweise gleichmässig, über den Querschnitt des Einkristalls sein.

Das Abkühlverfahren für Einkristalle soll minimale Wärmespannungen in diesen bewirken und keine Rissbildung in diesen zulassen.

Die Züchtung von profilierten Einkristallen hochschmelzender optisch durchsichtiger Metallverbindungen ist ein komplizierter mehrstufiger technologischer Prozess. Davon, wie jede Stufe dieses Prozesses durchgeführt wird, hängt die Ausbeute an brauchbaren Kristallen und die Beständigkeit technologischer Ausrüstungen ab, die einer der ihre Selbstkosten bestimmenden Hauptfaktoren sind.

Das wichtigste Kriterium des technologischen Prozesses der Züchtung von Einkristallen ist die Ausbeute an tauglichen Erzeugnissen, die nach dem Entsprechen der Qualität skriterien der Einkristallen zu einem erforderlichen Niveau bewertet werden. Für profilierte Saphireinkristalle in Form von Röhren, die in Natriumhochdrucklampen verwendet werden, wird beispielsweise die Ausbeute an brauchbaren Einkristallen durch folgendes bestimmt: die Röhrengeometrie (Abweichungen des Innendurchmessers einer Röhre ± 0,2 mm), die Beständigkeit gegen elektrischen Durchschlag (mindestens 50 kV/mm), die Lichtdurchlässigkeit (mindestens 92%) und kristallografische Desorientierung der Bausteine einer Röhre (bei einer Desorientierung von über 20° verringern sich wesentlich die mechanische Festigkeit und Lebensdauer von Röhren).

Bekannt ist ein Verfahren zur Züchtung von profilierten Einkristallen hochschmelzender optisch durchsichtiger Metallverbindungen (DE-B-2325I04), das darin besteht, dass man den Ausgangsstoff der jeweiligen hochschmelzenden Metallverbindung in der Atmosphäre eines inerten Gases unter der Einwirkung von Wärme, die von einem Erhitzer entwickelt wird, erschmelzt, einen Impfkristall in der Kristallisationszone abschmelzt, einen Einkristall aufwachsen lässt und ihn aus der Kristallisationszone bis zur erforderlichen Länge streckt, wobei die Schmelze kontinuierlich der Kristallisationszone über ein Kapillarsystem einer Formgebundsvorrichtung unter Änderung der Erhitzerleistung zugeführt wird, und danach den Einkristall von der Schmelze abreisst und abkühlt.

Um die Genauigkeit der geometrischen Abmessungen des profilierten Einkristalls zu sichern,benutzt man die optische Kontrolle der Höhe eines Stäbchens der Schmelze zwischen der Stirnfläche der Formgebungsvorrichtung und der Kristallisationsfront und hält diese Höhe des Stäbchens der Schmelze auf einem ständigen Niveau, indem man die Leistung des Erhitzers verändert. Dabei ist eine Überhitzung der Schmelze im Tiegel möglich, was zur Verschlechterung physikalischer Eigenschaften des Einkristalls führt.

Es ist hervorzuheben, dass nach dem Abreissen des Einkristalls von der Schmelze der Erhitzer gleich abgeschaltet wird und der Prozess der Abkühlung des Kristalls auf natürlichem Wege erfolgt, was zu einem Wärmestoss am Endteil des Einkristalls und dem Entstehen von Rissen in diesem Abschnitt führt. Alles das setzt die Ausbeute an brauchbaren Kristallen herab.

Bekannt ist auch ein Verfahren zur Züchtung von profilierten Einkristallen (P.I.Antonov und andere, "Poluchenie profilirovannykh monokristallov i izdely sposobom Stepanova", I98I, Nauka, Leningrad, S, I37-I42), das darin besteht, dass man in der Atmosphäre eines inerten Gases unter der Einwirkung von Wärme, die von einem Erhitzer entwickelt wird, den Ausgangsstoft der jeweiligen hochschmelzenden Metallverbindung erschmelzt, in der Kristallisationszone einen Impfkristall abschmelzt, einen Einkristall aufwachsen lässt und ihn aus der Kristallisationszone bis zur erforderlichen Länge streckt, wobei die Schmelze in die Kristallisationszone durch das Kapillarsystem einer Formgebungsvorrichtung unter Änderung der Erhitzerleistung kontinuierlich eingeführt wird, und man danach den Einkristall von der Schmelze abreisst und ihn abkühlt.

In diesem Verfahren zur Züchtung von profilierten Einkristallen hochschmelzender optisch durchsichtiger Metallverbindungen beträgt die Überhitzung der Schmelze im Tiegel etwa 40°C. Bei den Schmelztemperaturen hochschmelzender optisch durchsichtiger Metallverbindungen von etwa 2000°C intensiviert jedoch selbst eine Überhitzung um einige Grad die physikalisch- chemischen Wechselwirkungen im System "Schmelze-Einkristall", wodurch die physikalischen Eigenschaften von Einkristallen wesentlich beeinflusst, und zwar beeinträchtigt werden.

Ausserdem werden bei der Züchtung von Einkristallen verschiedenen Profils unterschiedliche Formgebungsvorrichtungen angewendet. Bei der Züchtung von profilierten Einkristallen erfolgen unprüfbare Veränderungen der realen Verhältnisse der Züchtung von Einkristallen, wodurch die Verteilung des Temperaturfeldes im System "Schmelze-Einkristall" wesentlich beeinflusst wird.

In diesem Verfahren wird die Abkühlung des Einkristalls nach dessen Abreissen von der Schmelze auch nicht geregelt, was zur Rissbildung im Einkristall führt.

Offenbarung der Erfindung

Der Erfindung liegt die Aufgabe zugrunde, ein Verfahren zur Züchtung von profilierten Einkristallen hochschmelzender optisch durchsichtiger Metallverbindungen mit solch einer Wärmehaltung zu entwickeln, die es ermöglicht, einen optimalen Charakter des Temperaturfeldes im System "Schmelze-Einkristall" zu erhalten und somit die Güte der Einkristalle zu erhöhen.

Die gestellte Aufgabe wird gelöst durch ein Verfahren zur Züchtung von profilierten Einkristallen hochschmelzender optisch durchsichtiger Metallverbindungen, das darin besteht, dass man in der Atmosphäre eines inerten Gases den Ausgangsstoff der jeweiligen hochschmelzenden Metallverbindung unter der Einwirkung von Wärme erschmelzt, die durch einem Erthitzer entwickelt wird, in der Kristallisationszone einen Impfkristall abschmelzt, einen Einkristall aufwachsen lässt, ihn aus der Kristallisationszone bis zur erforderlichen Länge unter ununterborchener Zuführung der Schmelze in die Kristallisationszone durch das Kapillarsystem einer Formgebungsvorrichtung und bei der Veränderung der Leistung des Erhitzers streckt, wonach man den Einkristall von der Schmelze abreisst und abkühlt, dadurch gekennzeichnet, dass man vor dem Erschmelzen des Ausgangsstoffes in die Kristallisationszone ein Kontrollteilchen des Ausgangsstoffes bringt, im Moment der Erschmelzung des Kontrollteilchens die Leistung P des Erhitzers registriert und das Erschmelzen des Ausgangsstoffes bei einer Leistung von (1,04-1,1) P des Erthitzers durchführt, des Abschmelzen des Impfkristalls bei einer Leistung von (1,03-1,08) P des Erthitzers, das Aufwachsen des Einkristalls bei einer Leistung von (1,02-1,08) P, das Strecken des Einkristalls aus der Kristallisationszone bei einer Leistung von (1,02-1,22) P, das Abkühlen des Einkristalls mit einer Geschwindigkeit von 20-30°C/min durch die Verminderung der Leistung des Erhitzers verwirklicht und beim Erreichen einer Temperatur des Einkristalls von 1600 bis 1550°C den Erhitzer abschaltet.

Im erfindungsgemässen Verfahren zur Züchtung von profilierten Einkristallen hochschmelzender optisch durchsichtiger Metallverbindungen ermöglicht die Anwendung eines Kontrollteilchens des Ausgangsstoffes, sehr genau die Leistung des Erhitzers bei dessen Erschmelzen zu fixieren und ziemlich enge Temperaturbereiche der Verfahren zur Züchtung von Einkristallen zu gewährleisten.

Das ermöglicht, den Ausgangstoff zu erschmelzen und den Einkristall bei einer Erhitzung der Schmelze von höchstens 30°C zu strecken, eine optimale Temperaturführung beim Abschmelzen des Impfkristalls, beim Aufwachsen des Einkristalls und bei der Züchtung des Einkristalls unter Berücksichtigung von realen Verhältnissen genau zu ermitteln, was wesentlich die Güte der zu züchtenden Einkristalle erhöht und die Ausbeute an brauchbaren Einkristallen um 35-40% steigert.

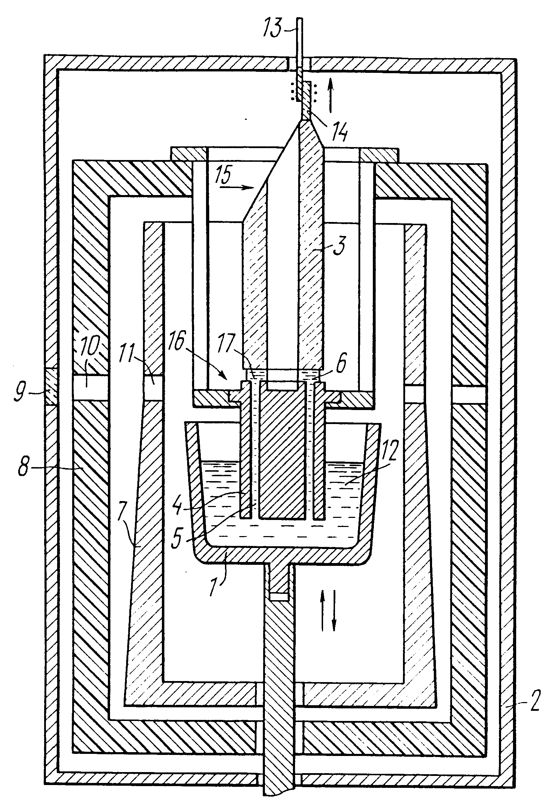

Kurzbeschreibung der Zeichnung

Nachstehend wird die Erfindung anhand einer konkreten Ausführungsvariante und beigelegten Zeichnung näher erläutert, in der eine Gesamtansicht der Einrichtung zur Züchtung von profilierten Einkristallen hochschmelzender optisch durchsichtiger Metallverbindungen im Längsschnitt, schematisch , in der Endstufe der Züchtung von Einkristallen dargestellt.

Eingehende Beschreibung der Erfindung

Das Verfahren zur Züchtung von profilierten Einkristallen hochschmelzender optisch durchsichtiger Metallverbindungen wird wie folgt durchgeführt.

In einen Tiegel 1, der in einer hermetisch abgeschlossenen Kammer 2 untergebracht ist und sich in der unteren Endstellung befindet (in der Zeichnung nicht angedeutet), bringt man den Ausgangsstoff der jeweiligen hochschmelzenden optisch durchsichtigen Metallverbindung zur Erhaltung eines Einkristalls 3 ein. Die Profile der zu züchtenden Einkristalle können in Abhängigkeit von der verwendeten Formegebungsvorrichtung, deren obere Stirn die den Querschnitt des Einkristalls nachanmende Form aufweist, verschieden sein: Röhren von rundem, drei- und rechteckigem Querschnitt, Röhren mit querliegenden Zwischenwänden, Stäbe von unterschiedlichem Querschnitt (darunter auch mit Längskanälen), Kappen, Tiegel, kleine Boote, Röhren und Stäbe mit Schraubenflächen. Die Formgebungsvorrichtung 4 einer in der Zeichnung dargestellten Variante hat ein Kapillarsystem zur Zuführung der Schmelze aus dem Tiegel an ihre obere Stirn, das in Form eines Ringkapillars 5 ausgeführt ist. In der beschriebenen Variante hat die obere Stirn 6 der Formgebungsvorrichtung 4 die Form eines Ringes. Man kann durch das erfindungsgemässe Verfahren profilierte Einkristalle verschiedener hochschmelzender optisch durchsichtiger Metallverbindungen, solcher wie Leukosaphir, Schmp. 2053°C, Rubin, Schmp. 2075°C, Skandiumoxid, Schmp. 2485°C, Yttriumtongranat, Schmp. 1950°C, züchten.

Der Ausgangsstoff der jeweiligen hochschmelzenden Metallverbindung in der Art von Stücken von verschiedener Form mit einem Volumen von etwa 1 bis 5 cm$^3$ wird in den Tiegel 1 eingebracht.

Dann wird auf die Stirn 6 der Formgebungsvorrichtung 4 das Kontrollteilchen des Ausgangsstoffes beliebiger Form (in der Zeichnung nicht angedeutet) gebracht.

Die Abmessungen des Kontrollteilchens des Ausgangsstoffes müssen derartig sein, dass sein maximales lineares Mass 2-3 mal so gross wie die Breite (oder der Durchmesser) des Kapillars 5 des Kapillarsystems der Formgebungsvorrichtung 4 ist.

Nach der Hermetisierung der Kammer 2 und deren Evakuierung wird geglüht, wozu eine Spannung dem Erhitzer 7 zugeführt wird, der in einem wärmeisolierenden Gehäuse 8 untergebracht ist, und unter der Einwirkung von Wärme, die von dem Erhitzer 7 entwickelt wird, erhitzt man den Tiegel 1 mit der Formgebungsvorrichtung 4 auf die Temperatur des Glühens von 1300 bis 1500°C, hält man auf dieser Temperatur innerhalb von 20-30 min zur Entgasung von Elementen der Einrichtung. Dann wird die Kammer 2 mit einem inerten Gas, beispielsweise Argon, unter einem Druck von 9,81x10$^4$ bis 10,79x10$^4$ Pa gefüllt. Danach erhöht man die Erhitzungstemperatur abhängig vom Schmelzpunkt der hochschmelzenden Metallverbindung, aus welcher man den Einkristall 3 züchtet, auf die Temperatur um 40-50°C niedriger dessen Schmelzpunktes, indem man die Leistung des Erhitzers 7 auf eine Leistung $P_o$ vergrössert. Die Erhitzungstemperatur wird zum Beispiel von einem Pyrometer kontrolliert.

Eine weitere Steigerung der Leistung des Erhitzers 7 erfolgt stufenweise bis zur Erschmelzung des Kontrollteilchens des Ausgangsstoffes: man vergrössert die Leistung des Erhitzers 7 um von 0,5 bis 1% $P_o$ mit einer Haltezeit nach jeder Vergrösserung von 5 bis 8 min. Man fixiert den Moment der Erschmelzung des Kontrollteilchens und registriert die Leistung P des Erhitzers 7 in diesem Moment. Man überwacht den Zustand des Kontrollteilchens durch Fenster 9, 10, 11, die in der Kammer 2, dem wärmeisolierenden Gehäuse 8 bzw. Erhitzer 7 in der Höhe der Stirn 6 der Formgebungsvorrichtung ausgeführt sind.

Die Erschmelzung des Ausgangsstoffes wird bei der Leistung des Erhitzers 7 gleich (1,04-1,1) P verwirklicht. Bei der Leistung des Erhitzers unterhalb 1,04 P wird die garantierte Erschmelzung des Ausgangsstoffes nicht gesichert, die Schmelzzeit nimmt stark zu, und der Energieaufwand vergrössert sich. Übertrifft die Leistung des Erhitzers 7 die Grösse 1,10 P, so überhitzt sich die Schmelze 12 und verstärken sich ihre Dissoziation und Wechselwirkung mit dem Material des Tiegels 1 und der Atmosphäre der Kammer 2. Dadurch erfolgt eine Verunreinigung des aufwachsenden Einkristells 3 und eine Vergrösserung der Menge von Gaseinschlüssen in seinem Volumen, was, seinerseits, zur Verringerung seiner Lichtdurchlässigkeit führt und die Beständigkeit gegen elektrischen Durchschlag und mechanische Festigkeit geringer macht. Durch die Vergrösserung der aufgenommenen Leistung wachsen die Selbstkosten des Einkristalls 3.

Nach der Erschmelzung des Ausgangsstoffes hebt man den Tiegel 1 in die obere Endstellung, die in der Zeichnung gezeigt ist, zunächst bis zum Kontakt der Schmelze 12 mit dem Kapillarsystem der Formgebungsvorrichtung 4 und weiter in die Arbeitsstellung, bei der die Entfernung zwischen der Oberfläche der Schmelze 12 im Tiegel 1 und der Stirn 6 der Formgebungsvorrichtung 4 eine Grösse von 20 mm beträgt.

Weiterhin wird die Stange 13 mit einem Impfkristall 14 bis zur Berührung desselben mit der Stirn 6 der Formgebungsvorrichtung 4 niedergesenkt, und der Impfkristall 14 wird bei der Leistung des Erhitzers von (1,03-1,08) P abgeschmolzen. Dabei bildet sich zwischen dem Impfkristall 14 und der Stirn 6 der Formgebungsvorrichtung 4 ein Stäbchen (in der Zeichnung nicht angedeutet) der Schmelze hochschmelzender optisch durchlässiger Metallverbindung. Der Form dieses Stäbchens nach, indem man es durch die Fenster 9, 10, 11 beobachtet, wählt man die Leistung des Erhitzers 7 aus, die für die Abschmelzung des Impfkristalls 14 nötig ist. Der Durchmesser des Stäbchens der Schmelze soll 0,7 bis 0,8 Durchmesser des Impfkristalls betragen. Wenn dieser Durchmesser in einem zulässigen Bereich liegt, lässt man die Leistung des Erhitzers 7 beim Abschmelzen des Impfkristalls 14 sich nicht ändern.

Wenn aber der Durchmesser des Stäbchens grösser als ein zulässiger ist, vergrössert man die Leistung des Erhitzers 7, und umgekehrt.

Bei der Leistung des Erhitzers 7 unterhalb 1,03 P wird keine zuverlässige Anhaftung des Impfkristalls 14 an dem Stäbchen der Schmelze, das an der Stirn 6 der Formgebungsvorrichtung entsteht, gesichert; infolgedessen entsteht an der Stelle der Impfung eine grösse Menge von Kristallbausteinen, die dann von dem aufwachsenden Einkristall 3 geerbt werden, und die mechanische Festigkeit sowie die Beständigkeit gegen elektrischen Durchschlag werden beim Einkristall 3 herabgesetzt. Möglich sind auch ausserordentliche Situationen: wenn am Impfkristall 14 die Schmelze des Stäbchens einfach angeklebt wird, in diesem Falle wird die Kristallorientierung auf den aufwachsenden Einkristall 3 nicht übertragen, und man erhält ein Muster mit polykristalliner Struktur. Und wenn die Leistung des Erhitzers 7 grösser als 1,08 P ist, schmilzt der Impfkristall 14 übermässig ab, und es erfolgt ein Abreissen des Schmelzstäbchens,wonach man eine erneute Impfung aber bei geringerer Leistung des Erthitzers 7 vornehmen muss.

Das Aufwachsen des Einkristalls 3 bis zum konstanten vorgegebenen Querschnitt erfolgt bei einer Bewegungsgeschwindigkeit des Impfkristalls 14 von 0,5 bis 1 mm/min. Die Leistung des Erhitzers 7 beim Aufwachsen beträgt (1,02-1,08) P. Dabei beobachtet man durch die Fenster 9, 10, 11 den Abschnitt 15 des Aufwachsens des Einkristalls 3, der konusförmig ist und einen spitzen Winkel von 40 bis 50° aufweisen soll. Zur Beibehaltung der Winkelgrösse in diesem Bereich verändert man jeweils die Leistung des Erhitzers 7.

Wenn die obere Grenze der Leistung des Erhitzers 7 grösser als 1,08 P ist, vollzieht sich der Prozess der Aufwachsung sehr langsam. Unbrauchbarer Abschnitt 15 des Aufwachsens im erhaltenen Einkristall 3 hat eine beträchtliche Länge, wodurch die Kosten von Kristallen höher werden. Wenn die untere Grenze der Leistung des Erhitzers 7 geringer als 1,02 P ist, so entwickelt sich durch schnelles Aufwachsen des Einkristalls 3 eine grosse Menge von Bausteinen in diesem mit der Desorientierung von 30° und darüber, wodurch die mechanische Festigkeit der Einkristalle 3 stark sinkt, sie können sogar beim Aufwachsen in der Kammer 2 unter der Einwirkung von Wärmespannungen, die in ihrem Volumen wirken, dekrepitieren. Nach der Stufe der Aufwachsung bildet sich in der Zone 16 der Kristallisation über der Stirn 6 der Formgebungsvorrichtung 4 ein Ringstäbchen 17 der Schmelze hochschmelzender optisch durchsichtiger Metallverbindung.

Beim Strecken des Einkristalls 3 aus der Kristallisationszone 16 hält man die Leistung des Erhitzers 7 im Bereich von (1,02-1,22) P, indem man sie vorzugsweise vergrössert, um vorgegebene Masse des Querschnitts des Einkristalls 3 mit notwendigen Toleranzen zu sichern. Die Streckungsgeschwindigkeit beträgt von 1 bis 5 mm/min. Wenn die Leistung des Erhitzers grösser als 1,22 P ist, so streckt man bei einer Höhe des Stäbchens 17 der Schmelze, die eine nominale von 0,2 bis 0,3 mm übersteigt. Die Masse des Querschnitts des erhaltenen Einkristalls 3 ist geringer als die notwendige, die bei dem hohen Stäbchen 17 der Schmelze entstehenden Kanten auf der Seitenfläche des Einkristalls verschlechtern noch mehr die Geometrie dessen Querschnitts. Dadurch wird die Ausbeute an brauchbaren Einkristallen nach ihrem Querschnitt gesenkt. Wenn die Leistung des Erhitzers 7 geringer als 1,02 ist, so ist die Höhe des Stäbchens 17 der Schmelze 12 weniger als die nominale, und der aufwachsende Einkristall 3 kann sich sogar an der Formgebungsvorrichtung 4 anfrieren. Dann ist es notwendig, den Prozess einzustellen. Im besten Fall entstehen im Einkristall 3 verschiedene Oberflächenfehler, von denen die Bausteinbauweise entwickelt wird; das setzt die Ausbeute an brauchbaren Einkristallen herab.

Nach der Züchtung eines Einkristalls 3 mit vorgegebener Länge reisst man ihn von der Schmelze ab, indem man zum Beispiel den Tiegel 1 senkt und den Einkristall 3 auf eine Temperatur von 1550 bis 1600°C abkühlt, wobei diese Abkühlung mit einer Geschwindigkeit von 20-30°C/min durch die Verringerung der Leistung des Erhitzers 7 erfolgt.

Die Länge des gezüchteten Einkristalls 3 kann bis 1000 mm und darüber betragen, sie hängt von der Bauart und von den Abmessungen der angewendeten Einrichtung zur Züchtung von profilierten Einkristalen ab.

Wenn bei der Abkülung des Einkristalls 3 die Geschwindigkeit der Verminderung der Temperatur 30°C übersteigt oder die untere Grenze der Temperatursenkung 1600°C übersteigt, so können, wie es Versuche zeigen, durch die beträchtliche Grösse thermoelastischer Spannungen am Ende des Einkristalls 3 Risse entstehen; an diesem Abschnitt bilden sich Risse und Absplitterungen. Die Ausbeute an brauchbaren Einkristallen verringert sich. Auch die Lebensdauer solcher Einkristalle wird vermindert. Die Abkühlung der Einkristalle 3 auf eine Temperatur von weniger als 1550°C oder mit einer Geschwindigkeit von unter 10°C/min ist unzweckmässig, da in diesem Fall lediglich die Prozessdauer verlängert wird, ohne dass die Güte des Einkristalls höher wird.

Nach der Senkung der Temperatur auf 1550°C wird der Erhitzer 7 abgeschaltet, und im weiteren wird der Einkristall 3 auf naturlichem Wege auf die Umgebungstemperatur gekühlt.

Zum besseren Verständnis der vorliegenden Erfindung werden nachstehend ihre konkreten Ausführungsvarianten beschrieben.

Beispiel 1

Man fertigte eine Partie Einkristalle in einer Menge von 10 Stück von Leukosaphir in Form von Röhren mit einem Aussendurchesser von 8, 7 mm, Innendurchmesser von 7,0 mm, einer Länge von 800 mm. In einen Tiegel aus Molybdän brachte man den Ausgangsstoff von Leukosaphir-Aluminiumoxidstücke von hoher Reinheit (99,9%) - ein. Zur Erhaltung von Röhren benutzte man eine Formgebungsvorrichtung aus Molgbdän; der Aussendurchmesser der oberen Stirn, auf die man ein Kontrollteilchen des Ausgangsstoffes brachte, ist gleich 8,8 mm, und der Innendurchmesser - 6,95 mm, die Höhe - 50 mm. Der Durchschnittsdurchmesser des Ringkapillars beträgt 7,9 mm, die Breite - 0,3 mm. Auf die Stirn der Formgebungsvorrichtung brachte man ein Kontrollteilchen des Ausgangsstoffes mit den Abmessungen $0,5 \times 0,8 \times 0,8 \text{ mm}^3$. Der Impfkristall hatte die Form eines Stabes mit einer Länge von 30 mm und einer Querschnittsfläche von $4 \text{ mm}^2$.

Dann schloss man die Kammer hermetisch ab, evakuierte Luft bis auf einen Druck von $7 \times 10^{-3}$ Pa und schaltete einen Erhitzer ein. Man erhitzte den Tiegel mit der Formgebungsvorrichtung auf eine Temperatur von 1350°C und glühte man während 30 min. Danach füllte man die Kammer mit Argon bis auf einen Druck von $9,91^4$ Pa. Weiterhin erhitzte man den Tiegel und die Formgebungsvorrichtung, indem man die Leistung des Erhitzers steigerte, auf eine Temperatur von 2000°C mit einer Haltezeit von 15 min. Die Leistung des Erhitzers $P_o$ war dabei 28,5 kW. Dann vergrösserte man die Leistung des Erhitzers stufenweise um 150 W mit einer Haltezeit in jeder Stufe von 5 min, indem man den Zustand des Kontrollteilchens beobachtete. Bei der Leistung P des Erhitzers gleich 29,1 kW schmolz das Kontrollteilchen.

Man erschmolz den Ausgangsstoff bei einer Leistung des Erhitzers von 30,26 kW, was 1,04 P beträgt. Das Abschmelzen d es Impfkristalls erfolgte bei einer Leistung des Erhitzers von 29,97 kW, was 1,03 P beträgt.

Man liess den Einkristall bei einer Leistung des Erhitzers von 29,6 kW aufwachsen, was 1,02 P beträgt, wobei der Impfkristall mit einer Geschwindigkeit von 0,5 mm/min bewegt wurde.

Man streckte den Einkristall mit einer Bewegungsgeschwindigkeit des Einkristalls gleich 5 mm/min. Die Leistung des Erhitzers wurde in einem Bereich von 29,68 bis 34,92 kW geändert, was (1,02-1,2) P beträgt. Der gezüchtete Einkristall mit einer Länge von 800 mm wurde von der Schmelze abgerissen. Allmählich die Leistung des Erhitzers verringernd, kühlte man ferner den Einkristall mit einer Geschwindigkeit von 30°C/min auf eine Temperatur von 1550°C. Danach wurde der Erhitzer abgeschaltet.

Die gezüchteten Einkristalle wurden in Stücke mit einer Länge von 100 mm geschnitten, und man führte nach der bekannten Methode eine Prüfung der Einkristalle durch: die Messung der geometrischen Masse des Querschnitts des Einkristalls mit einer Genauigkeit von 0,1 mm und die Ermittlung integraler Lichtdurchlässigkeit, der Beständigkeit gegen elektrischen Durchschlag, kristallografischer Desorientierung der Bausteine des Einkristalls und dessen mechanischer Festigkeit.

Die Ausbeute an brauchbaren Einkristallen betrug 86%.

Beispiel 2

Das Verfahren zur Züchtung von profilierten Einkristallen wurde wie in Beispiel 1 beschrieben durchgeführt, ausschliesslich dessen, dass man ein Kontrollteilchen des Ausgangsstoffes mit einem Mass von $0,5 \times 0,8 \times 0,5 \text{ mm}^3$ nahm. Die Glühtemperatur machte 1300°C aus. Der Druck von inertem Gas - $10,30 \times 10^4$ Pa. Der Ausgangsstoff wurde bei einer Leistung des Erhitzers von 31,14 kW erschmolzen was 1,07 P beträgt, der Impfkristall wurde bei einer Leistung des Erhitzers von 30,95 kW abgeschmolzen, was 1,08 P beträgt, der Einkristall wuchs bei einer Leistung des Erhitzers von 30,41 kW auf, was 1,08 P beträgt. Man strecke den Einkristall 3 mit einer Geschwindigkeit von 3,0 mm/min, indem man die Leistung des Erhitzers in einem Bereich von 31,41 bis 33,46 kW änderte, was (1,08 - 1,22) P beträgt. Man kühlte den Einkristall mit einer Geschwindigkeit von 25°C/min auf eine Temperatur von 1574°C. Die Ausbeute an brauchbaren Einkristallen betrug 86,5%.

Beispiel 3

Das Verfahren wurde wie in Beispiel 1 beschrieben durchgeführt, ausschliesslich dessen, dass man ein Kontrollteilchen mit einem Mass von $0,6 \times 0,6 \times 0,7 \text{ mm}^3$ nahm. Man glühte bei einer Temperatur von 1500°C. Der Argondruck in der Kammer war $10,79 \times 10^4$ Pa. Die Erschmelzung des Ausgangsstoffes führte man bei einer Leistung des Erhitzers von 32,01 kW, die Abschmelzung des Impfkristalls bei 31,43 kW, das Aufwachsen dem Einkristalls bei 31,43 kW durch. Das Strecken des Einkristalls führte bei einer Leistung von 31,43 bis 35,55 kW mit einer Geschwindigkeit von 2,0 mm/min. Die Einkristalle wurden auf eine Temperatur von 1600°C mit einer Geschwindigkeit von 20°C/min abgekühlt. Dann wurde der Erhitzer abgeschaltet. Die Ausbeute an brauchbaren Einkristallen betrug 88,5%.

Beispiel 4

Man fertigte eine Partie Röhren aus Leukosaphir in einer Menge von 10 Stück. Der Aussendurchmesser der Röhren ist gleich 20 mm, der Innendurchmesser - 18 mm, die Länge - 800 mm. Man wendete eine Formgebungsvorrichtung an, bei der der Aussendurchmesser der oberen Stirn gleich 20,2 mm, der Innendurchmesser - 17,9 mm, die Höhe - 50 mm, der durchschnittliche Durchmesser des Ringkapillars gleich 19,1 mm und die breite des Kapillars gleich 0,3 mm ist.

Die Abmessungen des Kontrollteilchens - 0,9 x 0,9 x x 0,7 mm³. Man glühte bei einer Temperatur von 1400°C während 30 min. Der Druck von inertem Gas in der Kammer - $8,81 \times 10^4$ Pa. Weiterhin wurde das Verfahren wie in Beispiel 1 beschrieben durchgeführt, ausschliesslich dessen, dass bei der Erschmelzung des Kontrollteilchens die Leistung P des Erhitzers gleich 29,8 kW war. Das Erschmelzen des Ausgangsstoffes erfolgte bei der Leistung des Erhitzers von 31,89 kW, das Abschmelzen des Impfkristalls - bei der Leistung von 31,29 kW, das Aufwachsen des Einkristalls - bei der Leistung 31,43 kW. Die Einkristallstreckung führte man mit einer Geschwindigkeit von 2,0 mm/min bei einer Leistung des Erhitzers von 31,58 bis 34,57 kW durch. Das Abkühlen des Einkristalls erfolgte bei einer Geschwindigkeit von 20°C/min auf eine Temperatur von 1600°C. Dann wurde der Erhitzer abgeschaltet. Die Ausbeute an brauchbaren Einkristallen betrug 75%.

Beispiel 5

Man fertige eine Partie Einkristalle aus Leukosaphir in einer Menge von 10 Stück in Form von Stäben mit einem Durchmesser von 12 mm. Der Durchmesser der oberen Stirn der Formgebungsvorrichtung ist gleich 12,3 mm, in der Achse der Formgebungsvorrichtung ist eine Kapillaröffnung mit einem Durchmesser von 2,0 mm ausgeführt. Das Verfahren wurde wie in Beispiel 1 durchgeführt, ausschliesslich dessen, dass ein Kontrollteilchen mit den Abmessungen 4 x 4 x 4 mm³ genommen wurde. Die Glühtemperatur betrug 1400°C, der Druck von inertem Gas- $10,3 \times 10^4$ Pa. Die Leistung P des Erhitzes beim Erschmelzen des Kontrollteilchens - 30,5 kW. Den Ausgangsstoff erschmolz man bei 33,55 kW, das Abschmelzen des Impfkristalls erfolgte bei 32,94 kW, das Aufwachsen des Einkristalls - bei 32,94 kW. Das Strecken des Einkristalls führt man mit einer Geschwindigkeit von 1 mm/min bei einer Leistung des Erhitzers von 32,94 bis 37,21 kW. Man kühlte die Einkristalle auf eine Temperatur von 1550°C mit einer Geschwindigkeit von 20°C/min. Die Ausbeute an brauchbaren Einkristallen betrug 78%.

Beispiel 6

Man fertigte eine Partie Einkristalle aus Rubin in einer Menge von 10 Stück in Form von Röhren mit einem Aussendurchmesser von 10 mm und Innendurchmesser von 8 mm. Man wendete eine Formgebungsvorrichtung an, bei der der Aussendurchmesser der oberen Stirn gleich 10,2 mm, der Innendurchmesser gleich 7,9 mm, die Breite den Ringkapillars gleich 7, 9 mm und dessen Durchschnittsdurchmesser gleich 9,0 mm ist.

Das Verfahren wurde wie in Beispiel 1 beschrieben durchgeführt, ausschliesslich dessen, dass man als Ausgangsstoff Rubinstücke (Aluminiumoxid mit Chromoxidzusätzen in einer Menge von 0,5 bis 3%) verwendete und ein Kontrollteilchen des Ausgangsstoffes mit Abmessungen von 0,9 x 0,6 x 0,6 mm³ nahm. Man glühte bei einer Temperatur von 1350°C. Der Druck des inerten Gases in der Kammer betrug $9,81 \times 10^4$ Pa. Man erhitzte die Formgebungsvorrichtung und den Tiegel auf eine Temperatur von 2030°C. Die Leistung P des Erhitzers beim Erschmelzen des Kontrollteilchens des Ausgangsstoffes - 30,2 kW. Das Erschmelzen des Ausgangsstoffes erfolgte bei einer Leistung des Erhitzers von 31,41 kW, das Abschmelzen des Impfkristalls - bei 31,11 kW, das Aufwachsen des Einkristalls - bei 30,80 kW. Das Strecken des Einkristalls erfolgte mit einer Geschwindigkeit von 1,5 mm/min bei einer Leistung des Erhitzers von 30,80 bis 33,22 kW. Man kühlte die Einkristalle mit einer Geschwindigkeit von 30°C/min auf eine Temperatur von 1550°C ab. Die Ausbeute an brauchbaren Einkristallen betrug 81%.

Beispiel 7

Man fertigte eine Partie Einkristalle von Rubin in einer Menge von 10 Stück in Form von Stäben mit einem Durchmesser von 3 mm. Der Durchmesser der oberen Stirn der Formgebungsvorrichtung - 3,1 mm, der Durchmesser der Kapillaröffnung - 1,5 mm. Das Verfahren wurde wie in Beispiel 1 beschrieben durchgeführt, ausschliesslich dessen, dass ein Kontrollteilchen des Ausgangsstoffes mit den Abmessungen 4 x 4 x 4 mm³ genommen wurde. Man glühte bei einer Temperatur von I450°C. Der Druck von inertem Gas betrug 10,79x10⁴ Pa. Der Tiegel und die Formgebungsvorrichtung wurden auf eine Temperatur von 2030°C erhitzt. Die Leistung P des Erhitzers beim Erschmelzen des Ausgangsstoffes war gleich 30,3 kW. Man erschmolz den Ausgangsstoff bei einer Leistung des Erhitzers von 33,33 kW, das Abschmelzen des Impfkristalls erfolgte bei 32,42 kW, das Aufwachsen des Einkristalls - bei einer Leistung von 32,72 kW. Das Strecken von Einkristallen führte man mit einer Geschwindigkeit von 1,0 mm/min bei einer Leistung des Erhitzers von 32,72 bis 36,96 kW. Man kühlte die Einkristalle mit einer Geschwindigkeit 20°C/min auf eine Temperatur von 1600°C. Die Ausbeute an brauchbaren Einkristallen betrug 79%.

Beispiel 8

Man fertigte eine Partie Einkristalle von Yttriumtongranat in einer Menge von 10 Stück (mit einem Schmelzpunkt von 1950°C) in Form von Röhren mit einem Aussendurchchesser von 10 mm und einem Innendurchmesser von 8 mm. Der Aussendurchmesser der oberen Stirn der Formgebungsvorrichtung ist gleich 10,3 mm, der Innendurchmesser -- 7,9 mm, der Durchschnittsdurchmesser des Ringkapillars - - 9,1 mm, die Breite des Kapillars - 0,25 mm.

Das Verfahren zur Züchtung von Einkristallen wurde wie in Beispiel 1 beschrieben durchgeführt, ausschliesslich dessen, dass man als Ausgangsstoff Stücke von Yttriumtongranat ($Y_3Al_5O_{12}$) verwendete und dass ein Kontrollteilchen des Ausgangsstoffes mit den Abmessungen 0,5 x 0,5 x 0,7 mm³ genommen wurde. Die Glühtemperatur betrug 1300°C, der Druck von inertem Gas - 9,91x10⁴ Pa. Man erhitzte den Tiegel und die Formgebungsvorrichtung auf eine Temperatur von 1900°C. Die Leistung P des Erhitzers betrug beim Erschmelzen des Kontrollteilchens 27,5 kW. Die Erschmelzung des Ausgangsstoffes erfolgte bei 30,25 kW, das Abschmelzen des Impfkristalls - bei 29,7 kW, das Aufwachsen des Einkristalls - bei 29,7 kW. Das Strecken des Einkristalls verwirklichte man bei einer Leistung des Erhitzers von 29,7 bis 33,55 kW und einer Geschwindigkeit von 2,0 mm/min. Man kühlte Einkristalle auf eine Temperatur von 1550°C mit einer Geschwindigkeit von 30°C/min. Die Ausbeute an brauchbaren Einkristallen betrug 72%.

Beispiel 9

Man fertigte eine Partie Einkristalle von Yttriumtongranat in einer Menge von 10 Stück in Form von Stäbenmit einem Durchmesser von 5 mm.Der Durchmesser der oberen Stirn der Formgebungsvorrichtung betrug 5,1 mm,der Durchmesser der in der Achse liegenden Kapillaröffnung beträgt 1,5 mm.

Das Verfahren zur Züchtung von Einkristallen wurde wie in Beispiel 1 beschrieben durchgeführt, ausschliesslich dessen, dass ein Kontrollteilchen des Ausgangsstoffes mit den Abmessungen 3 x 3 x 3 mm³ genommen wurde. Man glühte bei einer Temperatur von 1450°C, der Druck von inertem Gas betrug 69x10⁴ Pa. Man erhitzte den Tiegel und die Formgebungsvorrichtung auf eine Temperatur von 1900°C. Die Leistung P des Erhitzers beim Erschmelzen des Kontrollteilchens - 28,1 kW. Das Erschmelzen des Ausgangsstoffes erfolgte bei 29,22 kW, das Abschmelzen des Impfkristalls - bei 28,94 kW, das Aufwachsen des Einkristalls - bei 28,67 kW. Das Strecken des Einkristalls verwirklichte man mit einer Geschwindigkeit von 1,5 mm/min und bei einer Leistung des Erhitzers von 28,67 bis 32,31 kW. Man kühlte die Einkristalle auf eine Temperatur von 1600°C mit einer Geschwindigkeit von 20°C/min. Die Ausbeute an brauchbaren Einkristallen betrug 65%.

Beispiel 10

Man fertigte eine Partie Einkristalle von Skandiumoxid ($Sc_2O_3$) in einer Menge von 10 Stück mit einem Schmelzpunkt von 2485°C in Form von Stäben mit einem Durchmesser von 4 mm. Der Durchmesser der oberen Stirn der Formgebungsvorrichtung betrug 4,1 mm, der Durchmesser der in der Achse liegenden Kapillaröffnung - 1,5 mm. Das Verfahren zur Züchtung von Einkristallen wurde wie in Beispiel 1 beschrieben durchgeführt, ausschliesslich dessen, dass ein Kontrollteilchen des Ausgangsstoffes mit den Abmessungen 3 x 3 x 3 mm³ genommen wurde. Die Glühtemperatur betrug 1500°C, der Druck von inertem Gas- 9,81x10⁴ Pa. Man erhitzte den Tiegel und die Formgebungsvorrichtung auf eine Temperatur von 2440°C. Die Leistung P des Erhitzers beim Erschmelzen des Kontrollteilchens - 35,1 kW. Das Erschmelzen des Ausgangsstoffes erfolgte bei 88,61 kW, das Abschmelzen des Impfkristalls - bei 37,9I kW, das Aufwachsen des Einkristalls - bei 37,56 kW. Das Strecken des Einkristalls verwirklichte man mit einer Geschwindigkeit von 2,5 mm/min bei einer Leistung des Erhitzers von 37,56 bis 42,12 kW. Man kühlte die Einkristalle auf eine Temperatur von 1550°C mit einer Geschwindigkeit von 20°C/min. Die Ausbeute an brauchbaren Einkristallen betrug 77%.

Industrielle Anwendbarkeit

Das vorgeschlagene Verfahren zur Züchtung von profilierten Einkristallen hochschmelzender optisch durchsichtiger Metallverbindungen wird zur Erhaltung von Einkristallen von vorgegebener Form unterschiedlicher hochschmelzender optisch durchsichtiger Metallverbindungen, hauptsächlich von Leukosaphir, die praktisch keine mechanische Bearbeitung erfordern und die im Gerätebau, in der Chemie, Spezialmetallurgie und in den anderen Zweigen der Volkswirtschaft als Elemente der chemischen Apparate und optischen Geräte, als Eruptionskreuze von Erdölbohrungen, Container zur Synthese und Analyse extra reiner Legierungen und andere ähnliche Einrichtungen sowie als Halbzeuge von Schmuckstücken breit verwendet werden.

## Patentansprüche

1. Verfahren zur Züchtung von profilierten Einkristallen hochschmelzender optisch durchsichtiger Metallverbindungen, das darin besteht, dass man in der Atmosphäre eines inerten Gases den Ausgangsstoff der jeweiligen hochschmelzenden Metallverbindung unter der Einwirkung der Wärme erschmelzt, die durch einen Erhitzer (7) entwickelt wird, in der Kristallisationszone (16) einen Impfkristall (14) abschmelzt, einen Einkristall (3) aufwachsen lässt, ihn aus der Kristallisationszone (16) bis zur erforderlichen Länge unter ununterbrochener Zuführung der Schmelze (12) in die Kristallisationszone (16) durch das Kapillarsystem einer Formgebungsvorrichtung (4) und bei der Veränderung der Leistung des Erhitzers (7) streckt, wonach man den Einkristall (3) von der Schmelze (12) abreisst und abkühlt, dadurch **gekennzeichnet**, dass man vor dem Erschmelzen des Ausgangsstoffes in die Kristallisationszone (16) ein Kontrollteilchen des Ausgangsstoffes bringt, im Moment der Erschmelzung des Kontrollteilchens die Leistung P des Erhitzers (7) registriert und das Erschmelzen des Ausgangsstoffes bei einer Leistung von (1,04-1,1) P des Erhitzers (7) durchführt, das Abschmelzen des Impfkristalls (14) bei einer Leistung von (1,03-1,08) P des Erhitzers (7), das Aufwachsen des Einkristalls (3) bei einer Leistung von (1,02-1,08) P, das Strecken des Einkristalls (3) aus der Kristallisationszone (16) bei einer Leistung von (1,2-1,22) P und das Abkühlen des Einkristalls (3) mit einer Geschwindigkeit von 20-30°C/min durch die Verminderung der Leistung des Erhitzers (7) verwirklicht und beim Erreichen einer Temperatur des Einkristalls (3) von 1600 bis 1550°C den Erhitzer (7) abschaltet.

## Claims

1. A process for growing shaped single crystals of high-melting-point optically transparent metallic compounds, consisting in melting the starting material of the relevant high-melting-point metallic compound in an inert gas atmosphere and under the effect of heat generated by a heater (7), melting off a seed crystal (14) in the crystallizing zone (16), letting a single crystal (3) build up and drawing the latter from the crystallizing zone (16) to the required length while continuously feeding the melt (12) into the crystallizing zone (16) through the capillary system of a shaping device (4) and while varying the power of the heater (7), whereafter the single crystal (3) is torn away from the melt (12) and cooled, characterized in that prior to melting of the starting material a control particle of the starting material is introduced into the crystallizing zone (16), the power P of the heater (7) is recorded at the moment of melting of the control particle and melting of the starting material is carried out at a heater (7) power of (1.04-1.1)P, melting off of the seed crystal (14) is effected at a heater (7) power of (1.03-1.08)P, building up of the single crystal (3) at a power of (1.02-1.08)P, drawing of the single crystal (3) from the crystallizing zone (16) at a power of (1.2-1.22)P and cooling of the single crystal (3) at a rate of 20-30°C/min by lowering the power of the heater (7) and the heater (7) is switched off when the single crystal (3) reaches a temperature of 1600-1550°C.

## Revendications

1. Procédé de croissance des monocristaux profilés d'alliages métalliques transparents difficilement fusibles résidant en ce qu'on fond dans l'atmosphère d'un gaz inerte le produit de départ d'un alliage métallique respectif difficilement fusible sous l'action de la chaleur dégagée par un réchauffeur (7), on fait fondre un germe cristallin (14) dans la zone de cristallisation (16), on fait croître un monocristal (3) et on l'étire de la zone de cristallisation (16) jusqu'à une longueur voulue tout en amenant en continu l'alliage en fusion (12) dans la zone de cristallisation (16) par le système capillaire d'un dispositif de moulage (4) et en variant la puissance du réchauffeur (7), puis on détache le monocristal (3) de l'alliage en fusion (12) et on le refroidit, **caractérisé** en ce qu'avant la fusion du produit de départ on met, dans la zone de cristallisation (16), une particule témoin de contrôle du produit de départ, on enregistre la puissance P du réchauffeur (7) au moment de la fusion de ladite particule témoin de contrôle et on réalise la fusion du produit de départ à une puissance de (1,04 - 1,1)P du réchauffeur (7), la fusion du germe cristallin (14) à une puissance de (1,03 - 1,08)P du réchauffeur (7), la croissance du monocristal (3) à une puissance de (1,02 - 1,08)P, l'étirage du monocristal (3) de la zone de cristallisation (16) à une puissance de (1,02 - 1,08)P, l'étirage du monocristal (3) de la zone de cristallisation (16) à une puissance de (1,02 - 1,22)P, et le refroidissement du monocristal (3) est réalisé à une vitesse de 20 à 30°C/mn en diminuant la puissance du réchauffeur (7) et on débranche le réchauffeur (7) à une température du monocristal (3) atteignant de 1600 à 1550°C.